# EUROPEAN PATENT APPLICATION

(11) **EP 2 096 764 A1**
(43) Date of publication of application: **02.09.2009**
(21) Application number: 08300123.0
(22) Date of filing: 28.02.2008
(51) Int. Cl.: H03M 13/25

(54) **Methods and apparatus for generating trellis coded modulation codes**

(71) Applicant: THOMSON Licensing, 92100 Boulogne-Billancourt (FR)
(72) Inventor: Zhang, Xiaoxin, 100871 Beijing (CN); Zhao, Yuping, 100871 Beijing (CN); Zou, Li, 100088 Beijing (CN)
(74) Representative: Ruellan-Lemonnier, Brigitte

(57) **Abstract**

There are provided methods and apparatus for generating trellis-coded modulation codes. An apparatus includes an encoder (100) for generating trellis-coded modulation codes from coded sequences using criteria that considers both a maximization of a Euclidean distance between the coded sequences and a minimization of a number of error bits between the coded sequences when the Euclidean distance is of an identical value between the coded sequences.

## Description

### TECHNICAL FIELD

The present principles relate generally to coding and modulation of codes and, more particularly, to novel trellis-coded modulation codes and methods and apparatus for generating coded sequences.

### BACKGROUND

Trellis-coded modulation (TCM) is a very promising combined coding and modulation technique for digital transmission over band-limited channels. Trellis-coded modulation has been adopted by a number of international standards such as, for example, the Advanced Television Systems Committee (ATSC) Digital Television Standard. Trellis-coded modulation includes as one advantage the potential for significant coding gains over traditional un-coded multilevel modulation without comprising bandwidth efficiency.

A concept of trellis-coded modulation is to design coding and signal-mapping functions jointly so as to directly maximize the "free distance" (minimum Euclidean distance) between coded signal sequences. This design criteria ensures that the error probability between two arbitrary differently coded sequences is minimized. However, there are many bits in a coded sequence, and this criteria does not consider how to minimize the number of error bits between two coded sequences. Therefore, the performance of trellis-coded modulation codes can be further improved if considering the number of error bits. However, no existing trellis-coded modulation codes design criteria considers the number of error bits.

### SUMMARY

These and other drawbacks and disadvantages of the prior art are addressed by the present principles, which are directed to novel trellis-coded modulation codes and methods and apparatus for generating coded sequences.

According to an aspect of the present principles, there is provided novel trellis-coded modulation codes that satisfy the criteria of maximizing Euclidean distance between coded sequences and minimizing the number of error bits between the coded sequences for coded sequences having the same Euclidean distance.

According to another aspect of the present principles, there is provided an apparatus. The apparatus includes an encoder for generating trellis-coded modulation codes from coded sequences using criteria that considers both a maximization of a Euclidean distance between the coded sequences and a minimization of a number of error bits between the coded sequences when the Euclidean distance is of an identical value between the coded sequences.

According to another aspect of the present principles, there is provided a method. The method includes generating trellis-coded modulation codes from coded sequences using criteria that considers both a maximization of a Euclidean distance between the coded sequences and a minimization of a number of error bits between the coded sequences when the Euclidean distance is of an identical value between the coded sequences.

These and other aspects, features and advantages of the present principles will become apparent from the following detailed description of exemplary embodiments, which is to be read in connection with the accompanying drawings.

### BRIEF DESCRIPTION OF THE DRAWINGS

The present principles may be better understood in accordance with the following exemplary figures, in which:
FIG. 1 is a block diagram for an exemplary trellis-coded modulation code encoder to which the present principles may be applied, in accordance with an embodiment of the present principles;
FIG. 2 is a flow diagram for an exemplary method for generating trellis-coded modulation code, in accordance with an embodiment of the present principles;
FIG. 3A is a trellis diagram for an exemplary 2-state 8-phase shift keying trellis-coded modulation code, in accordance with an embodiment of the present principles;
FIG. 3B is a multi-dimensional constellation with 8 phase shift keying labeling for an exemplary signal set for the 2-state 8-phase shift keying trellis-coded modulation code of FIG. 3A, in accordance with an embodiment of the present principles;
FIG. 3C is a trellis diagram for an exemplary 2-state 8-phase shift keying trellis-coded modulation code, in accordance with the prior art;
FIG. 3D is a multi-dimensional constellation with 8 phase shift keying labeling for an exemplary signal set for the 2-state 8-phase shift keying trellis-coded modulation code of FIG. 3C, in accordance with the prior art;
FIG. 4A is a trellis diagram for an exemplary 4-state 8-phase shift keying trellis-coded modulation code, in accordance with an embodiment of the present principles;
FIG. 4B is a multi-dimensional constellation with 8 phase shift keying labeling for an exemplary signal set for the exemplary 4-state 8-phase shift keying trellis-coded modulation code of FIG. 4A , in accordance with an embodiment of the present principles;
FIG. 5 is a plot of performance comparisons between the proposed 2-state 8-phase shift keying trellis-coded modulation code shown and described with respect to FIGs. 3A-B, the proposed 4-state 8-phase shift keying trellis-coded modulation code shown and described with respect to FIGs. 4A-B, and the traditional best-performing 2-state and 4-state 8-phase shift keying trellis-coded modulation codes under additive white Gaussian noise (AWGN) channels;
FIG. 6A is a trellis diagram for an exemplary 4-state 16-quadrature amplitude modulation trellis-coded modulation code, in accordance with an embodiment of the present principles;
FIG. 6B is a multi-dimensional constellation with 16-quadrature amplitude modulation labeling for an exemplary signal set for the 4-state 16-quadrature amplitude modulation trellis-coded modulation code of FIG. 6A, in accordance with an embodiment of the present principles; and
FIG. 7 is a plot of performance comparisons between the proposed 4-state 16-quadrature amplitude modulation trellis-coded modulation code shown and described with respect to FIGs. 6A-B and the traditional best-performing 4-state 16-quadrature amplitude modulation trellis-coded modulation codes under additive white Gaussian noise (AWGN) channels.

### DETAILED DESCRIPTION

The present principles are directed to methods and apparatus for generating trellis-coded modulation codes.

The present description illustrates the present principles. It will thus be appreciated that those skilled in the art will be able to devise various arrangements that, although not explicitly described or shown herein, embody the present principles and are included within its spirit and scope.

All examples and conditional language recited herein are intended for pedagogical purposes to aid the reader in understanding the present principles and the concepts contributed by the inventor(s) to furthering the art, and are to be construed as being without limitation to such specifically recited examples and conditions.

Moreover, all statements herein reciting principles, aspects, and embodiments of the present principles, as well as specific examples thereof, are intended to encompass both structural and functional equivalents thereof. Additionally, it is intended that such equivalents include both currently known equivalents as well as equivalents developed in the future, i.e., any elements developed that perform the same function, regardless of structure.

Thus, for example, it will be appreciated by those skilled in the art that the block diagrams presented herein represent conceptual views of illustrative circuitry embodying the present principles. Similarly, it will be appreciated that any flow charts, flow diagrams, state transition diagrams, pseudocode, and the like represent various processes which may be substantially represented in computer readable media and so executed by a computer or processor, whether or not such computer or processor is explicitly shown.

The functions of the various elements shown in the figures may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor ("DSP") hardware, read-only memory ("ROM") for storing software, random access memory ("RAM"), and non-volatile storage.

Other hardware, conventional and/or custom, may also be included. Similarly, any switches shown in the figures are conceptual only. Their function may be carried out through the operation of program logic, through dedicated logic, through the interaction of program control and dedicated logic, or even manually, the particular technique being selectable by the implementer as more specifically understood from the context.

In the claims hereof, any element expressed as a means for performing a specified function is intended to encompass any way of performing that function including, for example, a) a combination of circuit elements that performs that function or b) software in any form, including, therefore, firmware, microcode or the like, combined with appropriate circuitry for executing that software to perform the function. The present principles as defined by such claims reside in the fact that the functionalities provided by the various recited means are combined and brought together in the manner which the claims call for. It is thus regarded that any means that can provide those functionalities are equivalent to those shown herein.

Reference in the specification to "one embodiment" or "an embodiment" of the present principles means that a particular feature, structure, characteristic, and so forth described in connection with the embodiment is included in at least one embodiment of the present principles. Thus, the appearances of the phrase "in one embodiment" or "in an embodiment" appearing in various places throughout the specification are not necessarily all referring to the same embodiment.

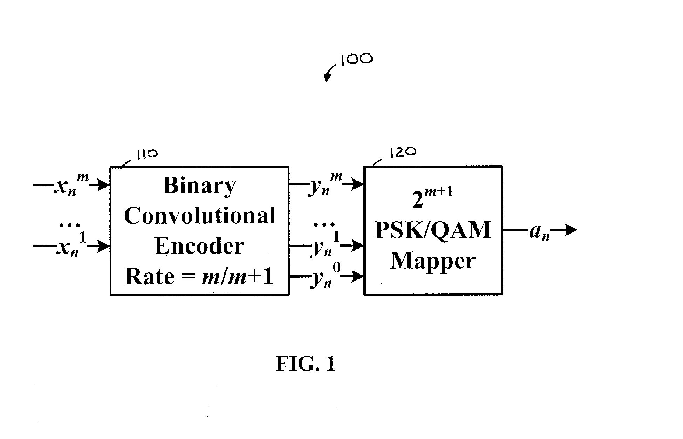

Turning to FIG. 1, an exemplary trellis-coded modulation code encoder to which the present principles may be applied in accordance with an embodiment of the present principles is indicated generally by the reference numeral 100.

The system 100 includes a binary convolutional encoder 110 and a 2^{*m*+1} phase shift keying/quadrature amplitude modulation (PSK/QAM) mapper 120.

The binary convolutional encoder 110, with an encoding rate equal to m/*m*+1, receives an m bits signal {*xₙ^{m}*, ..., *xₙ*¹} for encoding. The binary convolutional encoder 110 encodes the m bits signal {*xₙ^{m}*, ..., *xₙ*¹} to output an *m*+1 bits signal {*yₙ^{m}*, ..., *yₙ*¹, *yₙ*⁰}. The *m*+1 bits signal {*yₙ^{m}*, *yₙ*¹, *yₙ*⁰} is input to the 2^{*m*+1} PSK/QAM mapper 120 for mapping. The 2^{*m*+1} PSK/QAM mapper 120 maps the *m*+1 bits signal {*yₙ^{m}*, ..., *yₙ*¹, *yₙ*⁰} into a symbol *aₙ* in a 2^{*m*+1} PSK/QAM constellation.

The criteria used by the binary convolutional encoder 110 and the 2^{*m*+1} PSK/QAM mapper 120 involve both the maximization of the Euclidean distance between the coded sequences and the minimization of the number of the error bits between the coded sequences under the same Euclidean distance, as described in further detail herein below.

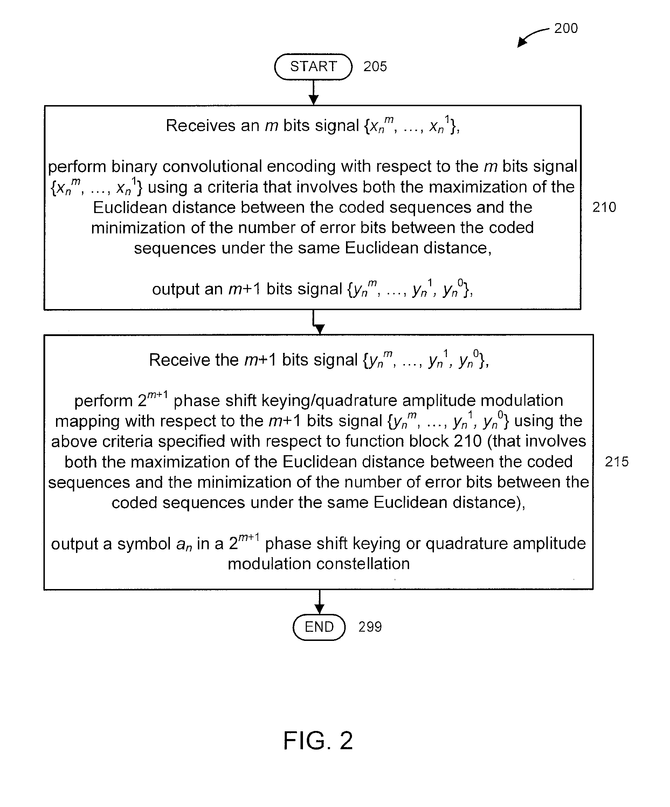

Turning to FIG. 2, an exemplary method for generating trellis-coded modulation code in accordance with an embodiment of the present principles is indicated generally by the reference numeral 200. The method 200 includes a start block 205 that passes control to a function block 210. The function block 210 receives an m bits signal {*xₙ^{m}*, ..., *xₙ*¹}, performs binary convolutional encoding with respect to the m bits signal {*xₙ^{m}*, ..., *xₙ*¹} using a criteria that involves both the maximization of the Euclidean distance and the minimization of the number of error bits for coded sequences having the same Euclidean distance, outputs an *m*+1 bits signal {*yₙ^{m}*, ..., *yₙ*¹, *yₙ*⁰}, and passes control to a function block 215. The function block 215 receives the *m*+1 bits signal {*yₙ^{m}*, ..., *yₙ*¹, *yₙ*⁰}, performs 2^{*m*+1} PSK/QAM mapping with respect to the *m*+1 bits signal {*yₙ^{m}*, ..., *yₙ*¹, *yₙ*⁰} using the above criteria specified with respect to function block 210 (that involves both the maximization of the Euclidean distance and the minimization of the number of error bits for coded sequences having the same Euclidean distance), outputs a symbol an in a 2^{*m*+1} PSK/QAM constellation, and passes control to an end block 299.

In accordance with various embodiments of the present principles, exemplary trellis-coded modulation codes are described herein. These proposed trellis-coded modulation codes are described by, for example, trellis diagrams used in the binary convolutional encoder 110 and signal sets used in the mapping module 120.

It is to be appreciated that the trellis-coded modulation codes designed in accordance with the present principles can be used in any systems that, in turn, use coding and modulation.

In contrast to the design criteria utilized for traditional trellis-coded modulation codes, the proposed trellis-coded modulation codes in accordance with the present principles are each designed using new different design criteria for trellis-coded modulation codes that considers both the maximization of the Euclidean distance between the coded sequences and the minimization of the number of the error bits between the coded sequences having the same Euclidean distance.

By using the new criteria, three new trellis-coded modulation codes are designed in accordance with the present principles that each perform better than the traditional best-performing trellis-coded modulation codes under additive white Gaussian noise (AWGN) channels with the same resources and complexity. Simulation results show that the proposed trellis-coded modulation codes achieve a 0.3dB∼0.4dB performance gain over the traditional best-performing TCM codes at a 10⁻³ bit error rate (BER).

Initially, exemplary 2-state 8-phase shift keying trellis-coded modulation codes in accordance with an embodiment of the present principles and exemplary 4-state 8-phase shift keying trellis-coded modulation codes in accordance with an embodiment of the present principles will be described.

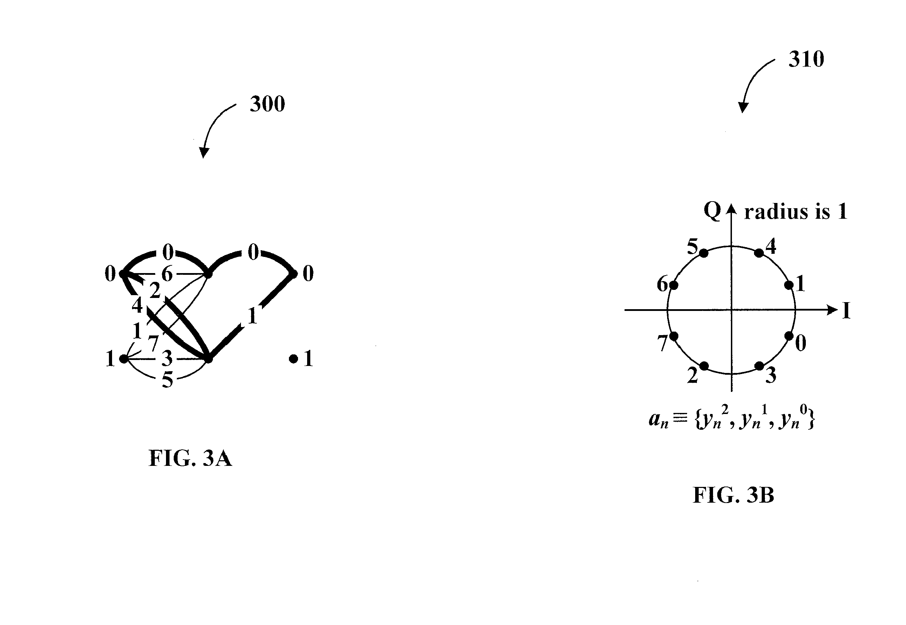

Turning to FIG. 3A, a trellis diagram for an exemplary 2-state 8-phase shift keying trellis-coded modulation code in accordance with an embodiment of the present principles is indicated generally by the reference numeral 300. Turning to FIG. 3B, an exemplary signal set for the 2-state 8-phase shift keying trellis-coded modulation code of FIG. 3A, in accordance with an embodiment of the present principles, is indicated generally by the reference numeral 310.

With respect to FIG. 3A, as known to those skilled in the art, for example, the phrase "state 0 is transferred to state 1 through path 2" refers to the following: when the present state of the convolutional encoder 110 is 0, if the input signal is {*xn*², *xₙ*¹} = {0, 1}, then the next state of the convolutional encoder 110 is 1, and the output signal is {*yₙ*², *yₙ*¹, *yₙ*⁰} = {0, 1, 0} = 2. The other paths in FIG. 3A can be determined in the same way. The signal is then mapped according to FIG. 3B. Here, the phrase "signal set 2" refers to the following: when the output signal is {*yₙ*², *yₙ*¹, *yₙ*⁰} = {0, 1, 0} = 2, then the output trellis-coded modulation code is an = exp(-j·5π/8). From FIG. 3B, we can calculate the square Euclidean distance between two code sequences. For instance, as to code sequence {0, 0} and {2, 1}, , we can calculate that the square Euclidean distance between {0} and {2} is 2, and the square Euclidean distance between {0} and {1} is 0.586, therefore the square Euclidean distance between the code sequences is 2.586.

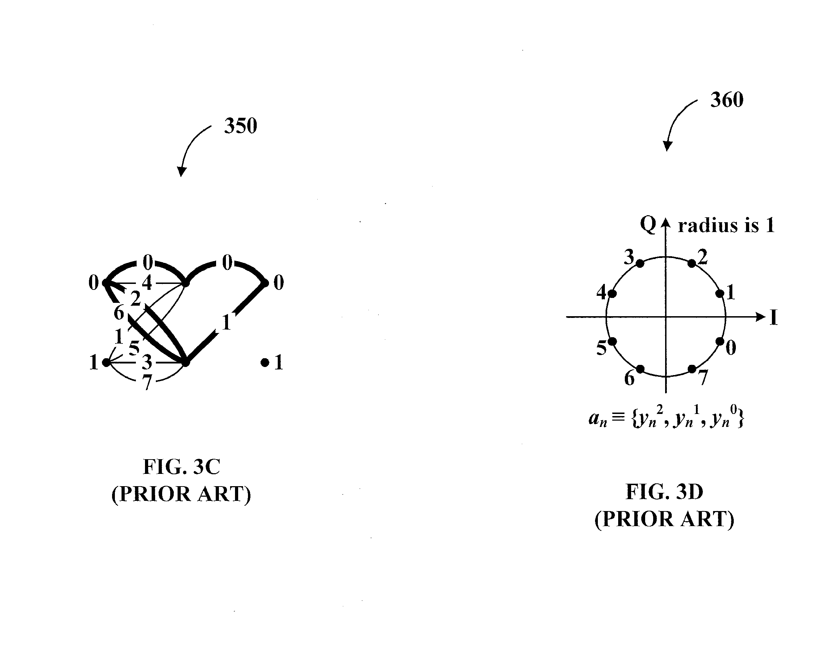

In contrast to FIG. 3A, turning to FIG. 3C, a trellis diagram for an exemplary 2-state 8-phase shift keying trellis-coded modulation code in accordance with the prior art is indicated generally by the reference numeral 350. In contrast to FIG. 3B, turning to FIG. 3D, an exemplary signal set for the 2-state 8-phase shift keying trellis-coded modulation code of FIG. 3C in accordance with the prior art is indicated generally by the reference numeral 360.

Similar to Fig. 3B, with respect to FIG. 3D, we can calculate that the square Euclidean distance between code sequences {0, 0} and {2, 1} is 2.586. According to the prior art, this is the minimum Euclidean distance among code sequences. Moreover, according to the prior art, this minimum Euclidean distance is maximized in all such 2-state 8-phase shift keying trellis-coded modulation codes, through computer search. This is significant because in a trellis-coded modulation code, the larger the minimum Euclidean distance is, the lower the error event probability. That is why the code depicted with respect to FIGs. 3C-D is the traditional best-performing trellis-coded modulation code.

However, from the above analysis we can see that the trellis-coded modulation code shown and described with respect to FIGs. 3A-B has the same minimum Euclidean distance as the traditional best-performing trellis-coded modulation code of the prior art shown and described with respect to FIGs. 3C-D. Therefore, the proposed trellis-coded modulation code is also a best-performing code. However, the proposed trellis-coded modulation code shown and described with respect to FIGs. 3A-B advantageously has less error bits under the same Euclidean distance compared with the traditional best-performing trellis-coded modulation code of the prior art shown and described with respect to FIGs. 3C-D. This can be seen in TABLE 1.

TABLE 1 shows a comparison of Euclidean distances and error bits numbers between the proposed exemplary 2-state 8-phase shift keying trellis-coded modulation code shown and described with respect to FIGs. 3A-B and the traditional best-performing 2-state 8-phase shift keying trellis-coded modulation code of the prior art shown and described with respect to FIGs. 3C-D. For illustrative purposes, we consider the square Euclidean distance 2.586 as an example. In the example, we presume that the transmitted code sequence is {0, 0}. With respect to the traditional code of the prior art shown and described with respect to FIGs. 3C-D, error sequences {2, 1} and {6, 1} correspond to the square Euclidean distance 2.586, error sequence {2, 1} has 1 error bit. This can be seen as follows.

The transmitted sequence {0, 0} is {'0 0 0', '0 0 0'} in bits, and the error sequence {2, 1} is {'0 1 0', '0 0 1'} in bits. However, only the first 2 bits in the 3 bits are information bits. Therefore, to calculate the error bits number, we only need to compare the first 2 bits, which are {'0 0', '0 0'} and {'0 1', '0 0'}. Therefore, there is 1 error bit between {0, 0} and error sequence {2, 1}. Similarly, the error sequence {6, 1} has 2 error bits and, thus, there are 3 error bits in total.

However, with respect to the proposed code shown and described with respect to FIGs. 3A-B, error sequences {2, 1} and {4, 1} correspond to square Euclidean distance 2.586, and the error bits are 2 bits in total, which is 1 error bit less than the traditional code. Similarly, we can get other error bits numbers under other Euclidean distance values, which are shown in TABLE 1. Thus, from TABLE 1, we can see that under the same Euclidean distance, the error bits of the proposed code are all less than those of the traditional code, except for a single case where the square Euclidean distance is 4. Therefore, the proposed code shown and described with respect to FIGs. 3A-B obtains better bit error rate performance than that of the prior art (shown and described with respect to FIGs. 3C-D).

**TABLE 1**

| Square Euclidean Distance | Traditional Best-Performing 2 State 8PSK-TCM Code | | Proposed 2 State 8PSK-TCM Code | |
|---|---|---|---|---|
| | Error Sequences | Error Bits Number | Error Sequences | Error Bits Number |
| 2.586 | {0,0}→{2,1} | 3 | {0,0}→{2,1} | 2 |
| | {0,0}→{6,1} | | {0,0}→{4,1} | |
| 3.172 | {0,0,0}→{2,7,1} | 7 | {0,0,0}→{2,3,1} | 4 |
| | {0,0,0}→{6,7,1} | | {0,0,0}→{4,3,1} | |
| 3.757 | {0,0,0,0}→{2,7,7,1} | 11 | {0,0,0,0}→{2,3,3,1} | 6 |
| | {0,0,0,0}→{6,7,7,1} | | {0,0,0,0}→{4,3,3,1} | |
| 4 | {0}→{4} | 1 | {0}→{6} | 2 |
| 4.343 | {0,0,0,0,0}→{2,7,7,7,1} | 15 | {0,0,0,0,0}→{2,3,3,3,1} | 8 |
| | {0,0,0,0,0}→{6,7,7,7,1} | | {0,0,0,0,0}→{4,3,3,3,1} | |
| ..... | ..... | ..... | ..... | ..... |

Compared with the traditional best-performing trellis-coded modulation code of the prior art shown and described with respect to FIGs. 3C-D, it can be observed that the proposed trellis-coded modulation code shown and described with respect to FIGs. 3A-B has the same number of states, path numbers, and constellation. Therefore, the trellis-coded modulation code shown and described with respect to FIGs. 3A-B has the same resources and complexity as compared with the traditional best-performing trellis-coded modulation code of the prior art shown and described with respect to FIGs. 3C-D, but can achieve better bit error rate (BER) performance.

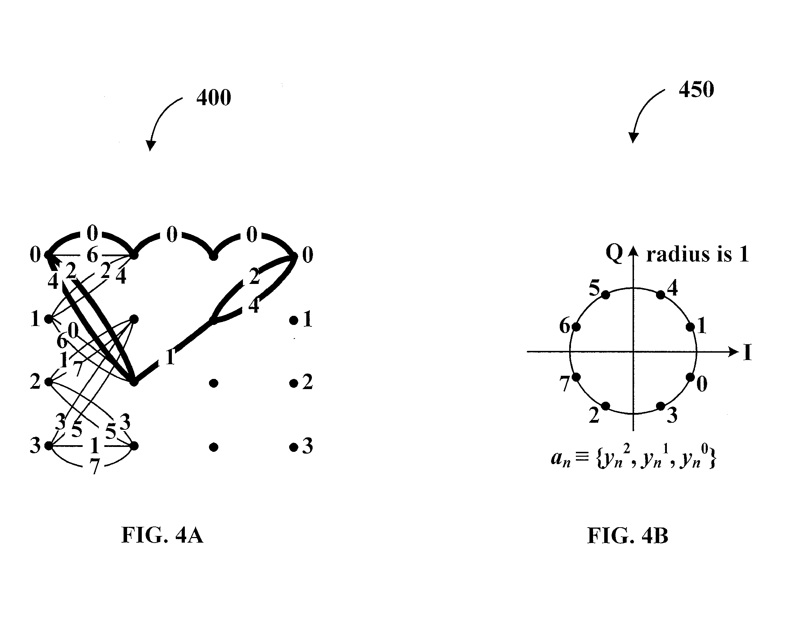

Turning to FIG. 4A, a trellis diagram for an exemplary 4-state 8-phase shift keying trellis-coded modulation code in accordance with an embodiment of the present principles is indicated generally by the reference numeral 400. Turning to FIG. 4B, an exemplary signal set for the 4-state 8-phase shift keying trellis-coded modulation code of FIG. 4A, in accordance with an embodiment of the present principles, is indicated generally by the reference numeral 450.

Compared with the traditional best-performing trellis-coded modulation code of the prior art, it can also be observed that the trellis-coded modulation code shown and described with respect to FIGs. 4A-B has the same minimum Euclidean distance and the same resources and complexity, but less error bits under the same Euclidean distance.

TABLE 2 shows a comparison of Euclidean distances and error bits numbers between the proposed exemplary 4-state 8-phase shift keying trellis-coded modulation code shown and described with respect to FIGs. 4A-B and the traditional best-performing 4-state 8-phase shift keying trellis-coded modulation code of the prior art. In TABLE 2, we can see that under the same Euclidean distance, the error bits of the proposed code are all less than those of the traditional code, except for a single case where the square Euclidean distance is 4. Therefore, the proposed code shown and described with respect to FIGs. 4A-B obtains better bit error rate performance than that of the prior art.

**TABLE 2**

| Square Euclidean Distance | Traditional Best-Performed 2 State 8PSK-TCM Code | | Proposed 2 State 8PSK-TCM Code | |
|---|---|---|---|---|
| | Error Sequences | Error Bits Number | Error Sequences | Error Bits Number |
| 4 | {0}→{4} | 1 | {0}→{6} | 2 |
| 4.586 | {0,0,0}→{2,1,2} | 12 | {0,0,0}→{2,1,2} | 8 |
| | {0,0,0}→{2,1,6} | | {0,0,0}→{2,1,4} | |
| | {0,0,0}→{6,1,2} | | {0,0,0}→{4,1,2} | |
| | {0,0,0}→{6,1,6} | | {0,0,0}→{4,1,4} | |
| 5.172 | {0,0,0,0}→{2,7,7,2} | 40 | {0,0,0,0}→{2,3,3,2} | 24 |
| | {0,0,0,0}→{2,7,7,6} | | {0,0,0,0}→{2,3,3,4} | |
| | {0,0,0,0}→{6,7,7,2} | | {0,0,0,0}→{4,3,3,2} | |
| | {0,0,0,0}→{6,7,7,6} | | {0,0,0,0}→{4,3,3,4} | |
| | {0,0,0,0,0}→{2,1,0,1,2} | | {0,0,0,0,0}→{2,1,0,1,2} | |
| | {0,0,0,0,0}→{2,1,0,1,6} | | {0,0,0,0,0}→{2,1,0,1,4} | |
| | {0,0,0,0,0}→{6,1,0,1,2} | | {0,0,0,0,0}→{4,1,0,1,2} | |
| | {0,0,0,0,0}→{6,1,0,1,6} | | {0,0,0,0,0}→{4,1,0,1,4} | |
| ..... | ..... | ..... | ..... | ..... |

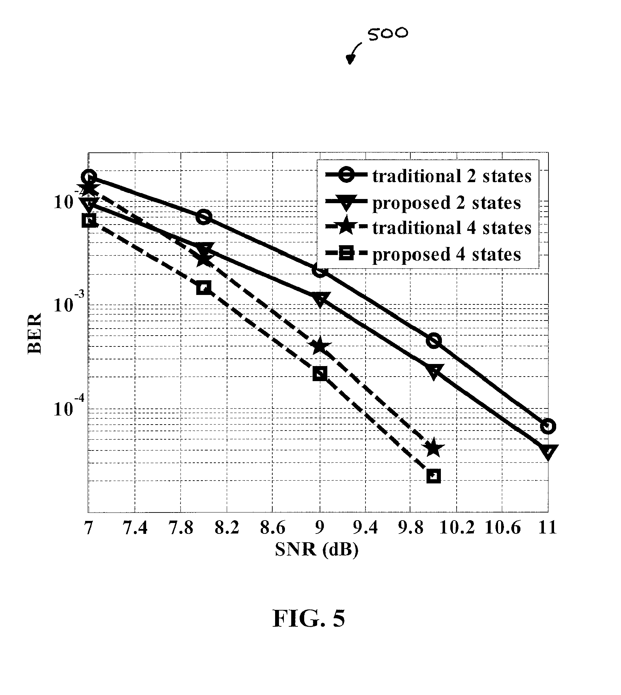

Turning to FIG. 5, performance comparisons between the proposed 2-state 8-phase shift keying trellis-coded modulation code shown and described with respect to FIGs. 3A-B, the proposed 4-state 8-phase shift keying trellis-coded modulation code shown and described with respect to FIGs. 4A-B, and the traditional best-performing 2-state and 4-state 8-phase shift keying trellis-coded modulation codes under additive white Gaussian noise (AWGN) channels are indicated generally by the reference numeral 500. The performance comparisons 500 are depicted in a plot of bit error rate (BER) versus signal-to-noise ratio (SNR) in decibels (dB). The performance comparisons 500 demonstrate that the proposed trellis-coded modulation codes achieve 0.3dB∼0.4dB performance gain at 10⁻³ BER than the traditional best-performing trellis-coded modulation codes.

An exemplary 4-state 16-quadrature amplitude modulation trellis-coded modulation code in accordance with an embodiment of the present principles and an exemplary 8-state 16-quadrature amplitude modulation trellis-coded modulation code in accordance with an embodiment of the present principles will be now described.

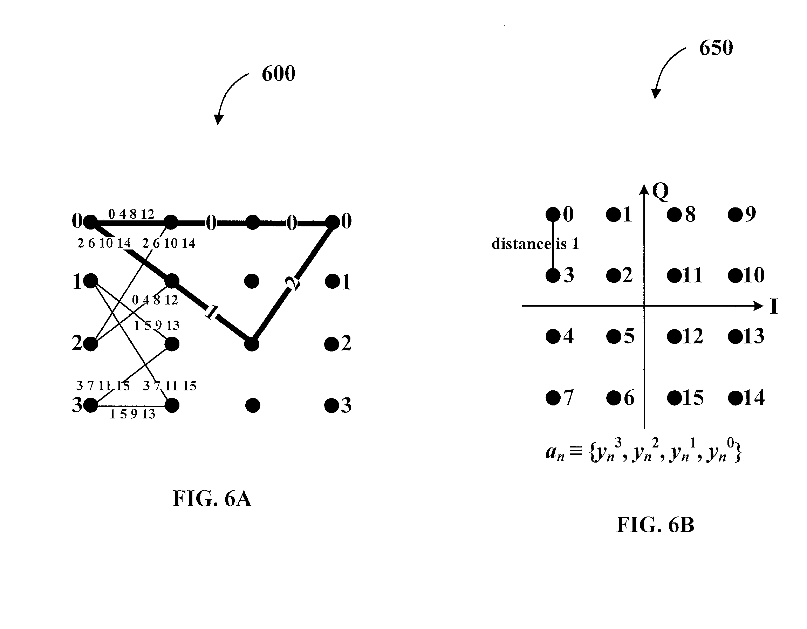

Turning to FIG. 6A, a trellis diagram for an exemplary 4-state 16-quadrature amplitude modulation trellis-coded modulation code in accordance with an embodiment of the present principles is indicated generally by the reference numeral 600. Turning to FIG. 6B, an exemplary signal set for the 4-state 16-quadrature amplitude modulation trellis -coded modulation code of FIG. 6A, in accordance with an embodiment of the present principles, is indicated generally by the reference numeral 650.

Compared with the traditional best-performing trellis-coded modulation code of the prior art, it can also be observed that the trellis-coded modulation code shown and described with respect to FIGs. 6A-B has the same minimum Euclidean distance and the same resources and complexity, but less error bits under the same Euclidean distance.

TABLE 3 shows a comparison of Euclidean distances and error bits numbers between the proposed exemplary 4-state 16-quadrature amplitude modulation trellis-coded modulation code shown and described with respect to FIGs. 6A-B and the traditional best-performing 4-state 16-quadrature amplitude modulation trellis-coded modulation code of the prior art. In TABLE 3, we can see that under the same Euclidean distance, the error bits of the proposed code are all less than those of the traditional code. Therefore, the proposed code shown and described with respect to FIGs. 6A-B obtains better bit error rate performance than that of the prior art.

**TABLE 3**

| Square Euclidean Distance | Traditional Best-Performed 4 State 16QAM-TCM Code | Proposed 4 State 16QAM-TCM Code |
|---|---|---|
| | Error Bits Number | Error Bits Number |
| 4 | 3 | 2 |
| 5 | 52.75 | 46.5 |
| 6 | 267.25 | 241.5 |
| 7 | 1194.5 | 1043.5 |
| ..... | ..... | ..... |

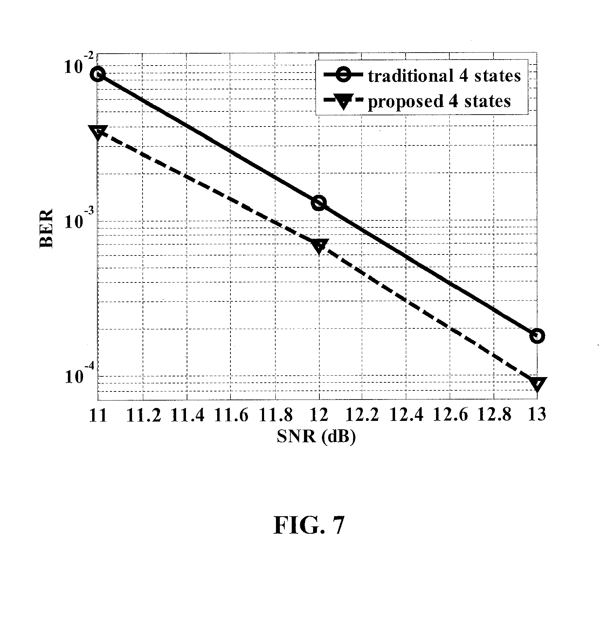

Turning to FIG. 7, performance comparisons between the proposed 4-state 16-quadrature amplitude modulation trellis-coded modulation code shown and described with respect to FIGs. 6A-B and the traditional best-performing 4-state 16-quadrature amplitude modulation trellis-coded modulation code under additive white Gaussian noise (AWGN) channels are indicated generally by the reference numeral 800. The performance comparisons 800 are depicted in a plot of bit error rate (BER) versus signal-to-noise ratio (SNR) in decibels (dB). The performance comparisons 800 demonstrate that the proposed trellis-coded modulation code achieves 0.3dB performance gain at 10⁻³ BER than the traditional best-performing trellis-coded modulation codes.

These and other features and advantages of the present principles may be readily ascertained by one of ordinary skill in the pertinent art based on the teachings herein. It is to be understood that the teachings of the present principles may be implemented in various forms of hardware, software, firmware, special purpose processors, or combinations thereof.

Most preferably, the teachings of the present principles are implemented as a combination of hardware and software. Moreover, the software may be implemented as an application program tangibly embodied on a program storage unit. The application program may be uploaded to, and executed by, a machine comprising any suitable architecture. Preferably, the machine is implemented on a computer platform having hardware such as one or more central processing units ("CPU"), a random access memory ("RAM"), and input/output ("I/O") interfaces. The computer platform may also include an operating system and microinstruction code. The various processes and functions described herein may be either part of the microinstruction code or part of the application program, or any combination thereof, which may be executed by a CPU. In addition, various other peripheral units may be connected to the computer platform such as an additional data storage unit and a printing unit.

It is to be further understood that, because some of the constituent system components and methods depicted in the accompanying drawings are preferably implemented in software, the actual connections between the system components or the process function blocks may differ depending upon the manner in which the present principles are programmed. Given the teachings herein, one of ordinary skill in the pertinent art will be able to contemplate these and similar implementations or configurations of the present principles.

Although the illustrative embodiments have been described herein with reference to the accompanying drawings, it is to be understood that the present principles is not limited to those precise embodiments, and that various changes and modifications may be effected therein by one of ordinary skill in the pertinent art without departing from the scope or spirit of the present principles. All such changes and modifications are intended to be included within the scope of the present principles as set forth in the appended claims.

## Claims

1. An apparatus, comprising:
an encoder (100) for generating coded sequences **characterized in that** when the Euclidean distance is same between coded sequences there is a minimization of a number of error bits between the coded sequences.

2. The apparatus of claim 1, **characterized in that** said encoder comprises:
means for encoding (110), with an encoding rate equal to *m*/*m*+1, for encoding, using the criteria of minimizing the number of error bits, an m bits signal {*xₙ^{m}*, ..., *xₙ*¹} to output an *m*+1 bits signal {*yₙ^{m}*, ..., *yₙ*¹, *yₙ*⁰}; and
means for (120) for mapping, using the criteria of minimizing the number of error bits, the *m*+1 bits signal {*yₙ^{m}*, ..., *yₙ*¹, *yₙ*⁰} into a symbol *aₙ* in a 2^{*m*+1} PSK/QAM constellation.

3. The apparatus of claim 1, **characterized in that** the trellis-coded modulation codes include two-state, eight-phase shift keying trellis coded modulation codes.

4. The apparatus of claim 1, **characterized in that** the trellis-coded modulation codes include four-state, eight-phase shift keying trellis coded modulation codes.

5. The apparatus of claim 1, **characterized in that** the trellis-coded modulation codes include four-state sixteen-quadrature amplitude modulation trellis-coded modulation codes.

6. The apparatus of claim 1, **characterized in that** the encoder generates a coded sequence in accordance with the diagram of fig. 3.

7. The apparatus of claim 1, **characterized in that** the encoder generates a coded sequence in accordance with the diagram of fig. 4.

8. The apparatus of claim 1, **characterized in that** the encoder generates a coded sequence in accordance with the diagram of fig. 6.

9. A method, **characterized by**:
generating (200) coded sequences such that when the Euclidean distance is same between the coded sequences there is a minimization of a number of error bits between the coded sequences.

10. The method of claim 9, **characterized in that** said generating step comprises:
performing a binary convolutional encoding (210), using an encoding rate equal to *m*/*m*+1, and also using the criteria of minimizing the number of error bits, on an m bits signal {*xₙ^{m}*, ..., *xₙ*¹} to output an *m*+1 bits signal {*yₙ^{m}*, ..., *yₙ*¹, *yₙ*⁰}; and
performing a 2^{*m*+1} PSK/QAM mapping (215) for mapping, using the criteria of minimizing the number of error bits, the *m*+1 bits signal {*yₙ^{m}*, ..., *yₙ*¹, *yₙ*⁰} into a symbol an in a 2^{*m*+1} PSK/QAM constellation.

11. The method of claim 9, **characterized in that** the trellis-coded modulation codes include two-state, eight-phase shift keying trellis coded modulation codes (300, 310).

12. The method of claim 9, **characterized in that** the trellis-coded modulation codes include four-state, eight-phase shift keying trellis coded modulation codes (400, 450).

13. The method of claim 9, **characterized in that** the trellis-coded modulation codes include four-state sixteen-quadrature amplitude modulation trellis-coded modulation codes (600, 650).

14. The method of claim 9, **characterized in that** the generating step comprises generating a coded sequence in accordance with the diagram of Fig. 3.

15. The method of claim 9, **characterized in that** the generating step comprises generating a coded sequence in accordance with the diagram of Fig. 4.

16. The method of claim 9, **characterized in that** the generating step comprises generating a coded sequence in accordance with the diagram of Fig. 6.
